# EUROPÄISCHE PATENTSCHRIFT

(11) **EP 0 361 542 B1**
(45) Veröffentlichungstag und Bekanntmachung des Hinweises auf die Patenterteilung: **01.02.1995**
(21) Anmeldenummer: 89121411.6
(22) Anmeldetag: 03.12.1986
(51) Int. Cl.: B32B 15/02, B32B 15/04, B32B 18/00, C01B 21/064, C01B 31/06, C23C 16/26, C23C 16/34, C23C 16/48, C23C 16/50

(54) **Verbundkörper und Verfahren zu deren Herstellung**
Composite articles and process for their production
Corps composites et procédé pour leur fabrication

(30) Priorität: 24.12.1985 DE 3546113
(43) Veröffentlichungstag der Anmeldung: 04.04.1990
(62) Teilanmeldung aus: 86116802.9
(73) Patentinhaber: Sumitomo Electric Industries, Ltd., Osaka 541 (JP)
(72) Erfinder: Lux, Benno, Prof.Dr., CH-7550 Scuol/GR (CH)
(74) Vertreter: Weber, Dieter, Dr.

(56) Entgegenhaltungen:
- EP-A- 0 157 212
- DE-A- 3 522 583
- CHEMICAL ABSTRACTS, Band 101, Nr. 11, 10. September 1984, Columbus, Ohio, US; SUMITOMO: "Coating with cubic boron nitride by vapor deposition", Seite 316, Spalte 2, Zusammenfassung Nr. 96 212y; & JP-A-59 80 775
- JOURNAL OF APPLIED PHYSICS, Band 47, Nr. 11, November 1976; S.P.CHAUHAN: "Kinetics of carbon deposition on diamond powder", Seiten 4746-4754
- ZEITSCHRIFT DER DEUTSCHEN GEMMOLOGISCHEN GESELLSCHAFT, Jahrgang 33, Heft 1/2, Juni 1984, Idar-Oberstein; K.RECKER: "Synthetische Diamanten", Seiten 5-34
- PATENT ABSTRACTS OF JAPAN, unexamined applications, C Field, Band 9, Nr. 267, 24. Oktober 1985, THE PATENT OFFICE JAPANESE GOVERNMENT, Seite 123 C 310
- PATENT ABSTRACTS OF JAPAN, unexamined applications, C Field, Band 9, Nr. 317, 12. Dezember 1985, THE PATENT OFFICE JAPANESE GOVERNMENT, Seite 2 C 319
- CHEMICAL ABSTRACTS, Band 104, Nr. 18, 5. Mai 1986, Columbus, Ohio, US; SATO MAMORU: "Coating of hard notride", Seite 351, Spalte 2, Zusammenfassung Nr. 154510u; & JP-A-60 196 559

## Beschreibung

Die Erfindung betrifft Verbundkörper, die aus einem Substrat mit einem daran anhaftenden Bornitridüberzug bestehen.

Patent Abstracts of Japan, C-Section, Band 9, Nr. 267, Seite 123 C 310 (JP-A-60-116 781) beschreibt hexagonales Bornitrid mit einem Überzug aus kubischem Bornitrid.

Journal of Applied Physics, Band 47, Nr. 11, Seiten 4746 bis 4754 (1976) betrifft Verbundkörper aus einem Diamantsubstrat mit einem Überzug aus Diamant oder einer anderen Kohlenstoffmodifikation, wobei die technische Lehre dieses Aufsatzes auf die Kinetik der Kohlenstoffablagerung auf Diamantpulver gerichtet ist. Die EP-A-0 157 212 beschreibt diamantartige Kohlenstoffüberzüge auf festen Substraten, die in erster Linie Kunststoffsubstrate sind. Die "Zeitschrift der Deutschen Gemmologischen Gesellschaft, Jahrgang 33, Heft 1/2, Juni 1984, Seiten 5 bis 34 betrifft synthetische Diamanten ohne Überzug.

Auch epitaxisch abgeschiedene Diamantschichten auf Diamantpulvern wurden vor einiger Zeit beschrieben mit dem Ziel, das Gewicht des Diamantpulvers zu erhöhen. Besondere Änderungen der physikalischen und chemischen Eigenschaften des Diamantpulvers wurden dabei nicht beabsichtigt (S. P. Chauhan, J. C. Angus, N. C. Gardner: J. of Appl. Phys. 47, 1976, Seiten 4746 bis 4754).

Für die Herstellung von Diamant-Schichten sind in der Literatur neue Verfahren zur Abscheidung von Diamant im metastabilen Bereich, im Unterdruck, beschrieben worden (K. Recker: Z. Dt. Gemmol. Ges. Nr. 1/2, 1984, 5/34).

Auch die Herstellung von superhartem BN wird in der Literatur mit analogen Methoden erwähnt (S. Komatsu, K. Akashi, T. Yoshida, Paper number P-5-11, Proceedings of the JSPC-7 Eindhoven, July 1985).

Die der Erfindung zugrundeliegende Aufgabe bestand nun darin, unterschiedlich anwendbare Verbundkörper mit verbesserten Eigenschaften und ein Verfahren zu deren Herstellung zu bekommen.

Diese Aufgabe wird mit Verbundkörpern gemäß Anspruch 1 und dem Verfahren gemäß Anspruch 5 gelöst.

Bevorzugt ist die Härte von Substrat und Überzug größer als 4500, besonders größer als 6000. Einige in den Modfikationen von Kohlenstoff, Bornitrid und anderen Phasen aus dem ternären System B,N,C auftretende Phasen oder Verbindungen können einzeln oder als Gemische oder als Übergangsstrukturen oder in der Form von Kristallgittern mit interstitiell eingelagerten Atomen oder als Mischkristalle oder als Kristallstrukturen, die mit einem hohen Anteil von Gitterfehlern behaftet sind, diese Härte erreichen.

Weiterhin ist es zweckmäßig, daß das Substrat ein- oder polykristallin und ein Karbid, z. B. SiC, B₄C, WC, TiC, TaC, ein Nitrid, z. B. TiN, TaN, ZrN, AlN, Si₃N₄, ein Borid, z. B. TiB₂, TaB₂, WB, ein Phosphid, z. B. BP, ein Sulfid, z. B. CaS, CeS, ein Silicid, z. B. MoSi₂, TiSi₂, ein Oxid, Oxynitrid, Oxycarbid, Oxycarbonitrid, z. B. Al₂O₃, AlNO, AlCON, Ti(C,O), Zr(C,N,O), ein NOSC (= Non-Oxide-Silicon-Ceramic) oder SiAlON ist.

Weiterhin ist es zweckmäßig, wenn das Substrat und der Überzug sich chemisch und/oder physikalisch in ihrer Strukter und/oder ihren Eigenschaften unterscheiden.

Eine Reihe von Kombinationsmöglichkeiten für fast vollständig aus superharten Stoffen bestehende Verbundkörper existiert.

### 1. Kombination: Einkristalliner superhartes Substrat mit einkristalliner superharter Umhüllung mit vom Kern verschiedenen chemischen und/oder physikalischen Eigenschaften.

Obwohl die der Erfindung zugrundegelegte Umhüllung mit einem superharten Stoff normalerweise nicht einkristallin ist, kann dies erzwungen werden, und zwar insbesondere dann, wenn auch der Kern aus einem einkristallinen Teilchen besteht und die Schicht auf diesem Kern epitaxisches Wachstum zeigt. Das Wachstum dieser Umhüllungsschicht ist dann aber nicht gleichmäßig. Ihre Dicke ist von den Kernkristallflächen abhängig und je nach Unterlagsflächen unterschiedlich. Das heißt, gewisse Kristallflächen und Kristallorientierungen werden dicker belegt werden und andere dünner. Hochindizierte Flächen werden normalerweise stärker belegt. Kristallgleichgewichtsformen mit niedrig indizierten Flächen treten dadurch bevorzugt im äußeren Erscheinungsbild auf und können die äußere Gestalt (Habitus) der Pulverteilchen stark bestimmen.

### 2. Kombination: Superhartes Substrat und chemische gleichartige aber polykristalline, superharte Umhüllung.

Beispielsweise ist die Herstellung von superharten Bornitridschichten mit speziellen physikalischen Eigenschaften auf einem ein- oder polykristallinen superharten Bornitridsubstrat möglich.

Ebenfalls ist es möglich, bei einem einkristallinen Substrat anstelle des einkristallinen Überzuges eine polykristalline Schicht herzustellen, die z. B. beim Schleifen oder Polieren besonders griffig bleibt. Dabei kann eine teilweise epitaxische Beziehung zwischen dem Kern und der aufgewachsenen Schicht bestehen.

Der Überzug wird sich aber im allgemeinen vom Substrat auch bei Verwendung der gleichen chemischen Substanz unterscheiden, z. B. in ihrer chemischen Zusammensetzung, in ihren physikalischen Eigenschaften, in ihrem inneren Aufbau, z. B. der Zahl und Art der Einschlüsse von Kristallfehlern und deren Dimension.

Wenn der Überzug sich vom superharten Substrat nur in den chemischen und/oder physikalischen Eigenschaften, jedoch nicht in seiner Kristallstruktur unterscheidet, können durch eine Änderung der Zusammensetzung oder der physikalischen Struktur des Überzuges besondere Eigenschaften erzielt werden.

Es ist so möglich, entweder durch chemische Zusätze (Doping) Änderung sowohl der physikalischen als auch der chemischen Natur in die äußere Schale einzuführen, oder während der Bildung dieser superharten Diamantschicht durch besondere Abscheidungsbedingungen (Veränderung der Keimzahl und Wachstumsgeschwindigkeit durch Änderung der Abscheidungstemperatur oder besondere Sättigung des Gasraumes mit den reagierenden Komponenten oder durch eine besondere Beeinflussung (Beschleunigung) der Ionen etc.) deren Eigenschaften so zu verändern, daß diese deutlich von den ursprünglich eingesetzten Kernen abweichen. Es ist ferner möglich, durch diese Verfahren auch von idealem Diamantkristall stark abweichende fehlerhafte und verzerrte Kristallgitter zu erzeugen, bis hin zu Übergangsformen, die z. B. Einschlüsse von Lonsdaleit, d. h. ausgeprägte Stapelfehler des Gitters und sogar bis hin zu Strukturen, die der Stoffgruppe der Carbine angehören oder teilweise amorphe Strukturen zeigen.

Mit Bornitrid als Überzug können Eigenschaftsänderungen gemäß den nachfolgenden Punkten 1 bis 4 erzielt werden, wobei beispielsweise durch Zusatz von je 0,01 bis 5 Atom-% und/oder Se und/oder Te, vorzugsweise durch Zusatz von 0,15 bis 0,3 Atom-% dieser Elemente, halbleitende Eigenschaften mit einer Aktivierungsenergie im Bereich von 0,01 bis 0,5 eV, vorzugsweise von 0,1 bis 0,2 eV, durch Zusatz von 0,001 bis 2 Atom-%, vorzugsweise von 0,05 bis 0,5 Atom-% Sb p-Typ-Halbleiter erhalten werden.
1. Änderung der optischen Eigenschaften:
   Farbe, z.B. blau (durch B-Zusätze), gelb-durchsichtig (durch N₂) oder braun bis schwarz (durch verschiedene Reinheitsgrade oder Verunreinigungen, z. B. durch Elemente wie Ni, Fe, Mn etc.). Damit verbunden sind z. B. bestimmte: Lichtbrechung, Lichtreflexion, Lichtszintilationseigenschaften, Röntgen-, Thermo-, Elektro- und Kathodoluminiszenz, z. B. mit verschiedenen Donor- und Akzeptorzentren, die durch Doping und/oder infolge Wachstumsfehler entstehen, anormale Doppelbrechung, Photoleitfähigkeit, UV- und/oder IR-Absorption oder Fluoreszenz und Phosphoreszenz.
2. Änderung der mechanischen, thermischen, morphologischen und anderer Eigenschaften, wie z. B.:
   Dichte, Härte, Festigkeit, E-Modul, Spaltbarkeit, Abriebbeständigkeit und Abriebfestigkeit, thermische Leitfähigkeit, Bildung besonderer Kristallfacetten (z. B. ausschließlich Oktaederflächen oder Würfelflächen durch Zusätze von Mn, Zr, Platinmetalle etc. oder [113] Facetten, z. B. durch B-Zusätze, wie oft auf Ge- und Si-Kristallen beobachtet, Typ I Diamanten bzw. Ia oder Ib ähnliche Diamanten mit hohen Stickstoffgehalten oder anderen besonderen Verunreinigungen oder Typ II bzw. Typ IIa oder IIb Diamanten, z. B. durch besonders niedrige Stickstoffgehalte.
3. Änderungen von elektrischen Eigenschaften, wie:
   elektrische Leitfähigkeit, Halbleitereigenschaft vom p-Typ (z. B. durch B-, Al- oder ähnlichen Zusatz oder Zusatz von freiem Kohlenstoff) mit besonderen Druck- und Temperaturabhängigkeiten, Halbleitereigenschaften vom n-Typ z. B. durch Legieren mit Stickstoff, P, As, Sb oder Li als Zwischengitter-Donoren und anderen geeigneten Elementen.
4. Änderung chemischer Eigenschaften, z. B.:
   Benetzbarkeit durch flüssige Metalle Legierungen etc. Benetzbarkeit durch oxidische und silicatische Schmelzen, Oberflächenreaktionsgeschwindigkeiten mit chemischen Stoffen, z. B. chemische Resistenz gegen oxidierende Medien, wie Sauerstoff, Salzschmelzen etc. oder reduzierende Medien, wie H₂, CO etc., Umwandlungskinetik (Geschwindigkeit) bei Erhitzen über 500 °C der superharten metastabilen Modifikationen in die stabilen Modifikationen.

Manche der hier aufgelisteten Eigenschaftsänderungen können zum Teil einzeln, zum Teil gemeinsam auftreten und ermöglichen eine starke Erweiterung der Nutzbarkeit derartiger mit superhartem BN überzogener Verbundkörper.

### 3. Kombination: Verbundkörper bestehend aus wenigstens zwei chemisch verschiedenen superharten Stoffen als Substrat oder Überzug (z. B. Diamantkern mit BN-Schicht.

Die Kombination von superhartem Bornitrid und superhartem Diamant ist von besonderem Interesse, da die beiden superhatten Stoffe sich in ihrern Polier-, Schleif- und Schneideigenschaften, z. B. gegenüber Stahl, Aluminium, Gesteinen u. a. Stoffen, wesentlich unterscheiden. Dabei ist das Substrat eine ein- oder polykristalline superharte Modifikation des Kohlenstoffs und die Umhüllung eine oder mehrere ein- oder polykristalline Phase(n) des superharten Bornitrids. Ebenso können hier alle anderen oben definierten Superhartstoffe mit Härten von über 3500 Vickers als Substrat verwendet werden.

### 4. Kombination: Superhartes Substrat mit superharter polykristalliner Schicht (chemisch gleich oder verschieden) sowie Ein lagerung ihrer stabilen Phasen in den Korngrenzen.

Eine weitere Möglichkeit ist, daß insbesondere bei den polykristallinen Schichten neben den superharten und metastabilen auch die normalen stabilen Phasen gleicher chemischer Zusammensetzung in gewissen Anteilen erzeugt werden können. Beispielsweise kann der Überzug je nach Herstellungsart mehr oder weniger große Anteile von Graphit und/oder amorphem Kohlenstoff enthalten. Dies bringt beispielsweise bei jenen Anwendungen Vorteile, wo die Pulverteilchen nachträglich in einer Hochdruckpresse zu einem größeren Körper verdichtet werden. Da der Graphit sehr fein verteilt ist, ist er in dieser Wirkung besonders günstig und besser geeignet als die dafür normalerweise zugesetzten Graphitpulveranteile.

Aber auch bei gewissen direkten Anwendungen der Verbundpulver zum Schleifen und Polieren hat der Graphitanteil eine positive Wirkung auf die Schleif- und Polierwirkung, da er infolge seiner Gleiteigenschaften und seiner besonderen Verteilung im Verbundkörper den Vorgang der Oberflächenglättung günstig beeinflußt.

Dies gilt für die superharten kubischen bzw. hexagonalen Bornitridphasen und die amorphen oder die normalerweise hexagonal auftretenden weichen Schichtstrukturen des Bornitrids. Hier kann die gleichzeitige Erzeugung dieser Nichthartstoffphasen durch geeignete Prozeßbedingungen gesteuert werden.

Im folgenden sind einige Stoffbeispiele aufgelistet, die zahlreiche weitere Kombinationen zeigen; denn der Erfindung entsprechend wird ein Verbundkörper hergestellt, bestehend aus einem in seiner Natur und seiner Größe sehr variablen Substrat, das von einer anhaftenden, vorzugsweise fest anhaftenden, äußeren Schale umhüllt wird. Diese besteht Vollständig oder nur teilweise aus superhartem Bornitrid und ist in ihren Dimensionen und in der Wahl der nicht superharten Zwischenschichten in weiten Bereichen variierbar. Derartige Zwischenschichten können im Prinzip aus dem gleichen Stoff die die nachfolgend beschriebenen Kernmaterialien ausgewählt werden.

Der Überzug besteht aus wenigstens einer Lage aus superhartem Bornitrid, wobei der Kern z. B. aus einer der oben aufgelisteten Substanzen besteht und wobei die äußere superharte Schale epitaxisch auf einem einkristallinen Kern aufgewachsen ist oder jede kristallographische Beziehung zwischen dem Kern und der ersten Schale fehlt, oder Übergänge zwischen den beiden Extremfällen in beliebigen Maß auftreten können oder die polykristalline Schale neben dem superharten Stoff den gleichen Stoff in seiner stabilen Modifikation enthält, welche in der Korngrenze vorkommt, wobei zusätzlich entweder weiches hexagonales und/oder amorphes BN auftritt.

Die Dimensionen des Verbundkörpers sowie die Größe des Substrates bzw. der Umhüllung kann in weiten Grenzen variiert werden, z. B. ist der Durchmesser des inneren Kernpartikels bei gewissen Pulvern, die alle für superharte Pulver heute übliche Durchmesser erreichen können, bei bewußt gewählten Versuchsbedingungen infolge homogener Keimbildung oder aus spontan sich bildenden Reaktionsprodukten (heterogene Keime) aus der stark übersättigten Gasphase sehr viel kleiner als 0,01 »m und daher praktisch auch mit den üblichen wissenschaftlichen Methoden nur schwer nachweisbar. Weist der Durchmesser des inneren Kernpartikelchens eine Größe von 0,01 bis 100 »m, vorzugsweise jedoch zwischen 1 und 10 »m, auf, liegt der äußere Durchmesser des Pulververbundteilchens zwischen 1 »m und mehreren 1000 »m, vorzugsweise aber im Bereich zwischen 10 und 100 »m, haben die einzelnen Schichten oder äußeren zusammenhängenden Schale jeweils eine Dicke zwischen 0,1 und 5000 »m, jedoch vorzugsweise zwischen 1 und 5 »m.

Auch der Aufbau ist variabel. Es können zum Beispiel die äußeren Schichten der Schale in gewisser Reihenfolge aufgebracht werden und zueinander in einem geordneten und regelmäßigen Verhältnis stehen, die in der äußeren Schale liegenden Schichtdicken des superharten Stoffes im Bereich zwischen 1 und 5 »m liegen, wobei die Hartstoffschichtdicke nur etwa die Hälfte bis ein Zehntel dieser Dicke betragen soll, die in der Schale liegenden Schichten des superharten Stoffes zwischen 100 und 500 »m liegen und der Hartstoff etwa gleich dick wie die Superhartstoffschicht sein.

Das erfindungsgemäße Verfahren zur Herstellung von Verbundkörpern besteht darin, daß die Substrate in einen Reaktionsraum gelegt oder aufgehängt und darin mittels chemischen Gasphasenabscheidungsverfahrens (CVD-Verfahren) mit Hilfe eines Gasstromes bei einer Temperatur zwischen 500 und 1200 °C und einem Druck unter 66 650 Pa beschichtet werden, wobei der Gasstrom aus einer gas- oder dampfförmigen Borverbindung oder einer Bor und Stickstoff enthaltenden Verbindung und/oder Wasserstoff und/oder Stickstoff und/oder Halogen und/oder deren Verbindungen mit oder ohne Edelgaszusatz besteht, und in diesen Fällen wenigstens eines der Gase durch ein physikalisches oder chemisches Verfahren in einen angeregten Zustand gebracht wurde.

Durch eine geeignete Gasanregung müssen die Bor enthaltenden Gasmoleküle und/oder ein zweites Gas, wie z. B. Wasserstoff, Halogene oder Gemische daraus, in einen solchen Zustand gebracht werden, daß die Bildung der weichen hexagonalen Bornitridphase oder amorpher Phasen unterdrückt oder kontrolliert werden kann und die superharten Phasen als Hauptbestandteile oder ausschließlich abgeschieden werden.

Die oben erwähnte Anregung bzw. die Modifikation der Borverbindungen gelingt durch die Verwendung von Verfahren, die die gasförmigen Moleküle oder Atome entsprechend aufbricht und kurzlebige Ionen, Radikale oder atomare Gasspezien erzeugt. Dies kann auf verschiedene Art geschehen, beispielweise durch Erhitzen z. B. mit Hilfe einer glühenden Metalloberfläche, z. B. eines Ta- oder W-Drahtes, -Rohres oder -Netzes mit entsprechend hoher Temperatur, durch Gasentladungen im Unterdruck, ausgelöst von Gleich- oder Wechselströmen, durch die Anwendung eines kalten Plasmas, hergestellt durch elektromagnetische Wellen vorzugsweise im Mega- und Gigahertz-Bereich, durch Ultraschall bzw. Druckwechsel, durch die Verwendung rein chemischer Verfahren, wie z. B. durch Zersetzung von HJ oder HBr mit Licht, wobei die Bildung von atomarem Wasserstoff und Halogenen erzwungen wird. Werden dabei Stoffe verwendet, die als Endprodukt eine bei Reaktionstemperatur feste oder flüssige Phase bilden, so können diese als Kerne (heterogene Keime) des superharten Stoffes auftreten.

Derartige Anregungsverfahren sind zum Teil in den oben genannten Patenten enthalten und zum Teil auch in der älteren Literatur bereits erwähnt.

Es eignen sich insbesondere jene CVD-Verfahren, z.B. mit up-stream-Reaktoren, bei denen dieser Anregungszustand der Gase, bevor diese die Substrate erreichen, nicht zu stark verlorengeht und außerdem die in den Normalzustand zurückgekehrten Gasmoleküle, nach ihrer Reaktion oder auch unverbraucht, möglichst geringe Konzentrationen in der Wirbelschicht erreichen. Das heißt, sie müssen aus dieser so rasch wieder entfernt werden, daß sie den Ablauf der gewünschten Reaktion nicht stören. Die Wirbelbettkonstruktion muß daher in Bezug auf die Verweilzeit der Gase den Bedürfnissen und der Kinetik der Abscheidungsreaktionen möglichst optimal angepaßt werden.

In Betracht zu ziehen sind unter anderem Verfahren mit Hilfe einer chemischen Gasphasenreaktion, Verfahren mit einer speziellen CVD-Reaktion in einem Upstream- oder Wirbelschichtreaktor, in welchem Substrate in einem Gasstrom beschichtet werden können.

Die obigen Verfahren sind dadurch charakterisiert, daß sie für die Herstellung der Verbundkörper ganz oder teilweise ein spezielles CVD-Verfahren, geeignet für die Herstellung von Superhartstoffen, einsetzen, wobei verwendet werden:
ein Gasstrom bestehend aus einer gas- oder dampfförmigen Borverbindung bzw. festen bzw. flüssigen Borverbindungen (z. B. Borhalogenide, Borane, Borazine, Bor-Mg-, Bor-Al-Verbindugnen), die solche bleiben können - mit oder ohne atomarem und molekularem Wasserstoff - und atomarem und molekularem Stickstoff, sowie entsprechenden Ionen und Radikalen, die aus den Ausgangskomponenten entstehen können,
ein Gasstrom bestehend aus einer gas- oder dampfförmigen Borverbindung (z. B. Borhalogenide, Borane, Borazine, Bor-Mg-, Bor-Al-Verbindungen etc.) - mit oder ohne atomarem und molekularem Wasserstoff - sowie atomarem und molekularem Stickstoff und/oder atomarem und molekularem Halogen oder Verbindungen dieser Stoffe, sowie Ionen und Radikalen, die aus den Ausgangskomponenten entstehen können,
ein Gasstrom, der eine gas- oder dampfförmige Verbindung enthält, die neben anderen Atomen Bor- und Stickstoffatome als wesentliche Bestandteile aufweist, die bei starkem Erhitzen in BN zerfällt, und deren Gas oder Dampf in Verbindung mit anderen atomaren oder molekularen Gasen, wie Wasserstoff und/oder Stickstoff und/oder Halogen und/oder Edelgasen bzw. Verbindungen dieser Stoffe, Ionen, Radikale, atomare Spezien, die aus den Ausgangskomponenten dieser Mischung entstehen können, enthält.

Wenn in der Beschreibung oder den Ansprüchen von gas- oder dampfförmigen Kohlenstoffverbindungen die Rede ist, so sind damit organische Kohlenstoffverbindungen mit Wasserstoff und/oder Sauerstoff und/oder Stickstof und/oder Schwefel und/oder Phosphor gemeint.

Die Verfahren sind ferner dadurch charakterisiert, daß der Temperaturbereich, in dem sich die zu beschichtenden Pulver bewegen, zwischen 500 und 1200 °C liegt, die Beschichtung im Druckbereich unter 666 mbar (500 Torr), vorzugsweise im Bereich zwischen (0,67 und 66,7 mbar (0,5 und 50 Torr), betrieben wird, der Betrieb im diskontinuierlichen oder kontinuierlichen Betrieb geführt werden kann.

### Beispiel

| Substrat | SiAlON |
|---|---|
| Gasdurchflußgeschwindigkeit: | 20 cm³/min |
| Temperatur des Ta-Glühfadennetzes: | 2100 °C |
| Temperatur des Wirbelbettes: | 750 °C |
| Gasdruck: | 20 Torr |
| Reaktionszeit: | 5 h |

### Versuchsdurchführung

Beschicken der Apparatur mit SiAlON-Substrat Aufheizen unter Wasserstoff, anschließend kurze Ätzperiode (10 min) mit reinem H₂ unter zeitweiser Zuhilfenahme eines glühenden Wolframdrahtnetzsystems.

Anschließend wird umgeschaltet auf eine andere Anregungsquelle mit Mikrowellen 4,8 GHz. Es werden neue Gase, bestehend aus 1 % Boran, 2 % Ammoniak, Rest Wasserstoff und geringen Zusätzen von Fluor eingebracht. Während 5 h wird superhartes Bornitrid abgeschieden.

## Patentansprüche

1. Verbundkörper bestehend aus einem Substrat, das mit einem daran anhaftenden Bornitridüberzug versehen ist, **dadurch gekennzeichnet**, daß das Substrat aus Diamant oder einer anderen Kohlenstoffmodifikation mit einer Härte von mehr als 3500 Vickers oder aus einem bei Temperaturen bis 1000 °C mit Kohlenstoff und/oder Bornitrid nicht oder höchstens wenig reagierenden und sie bis zu dieser Temperatur nicht oder höchstens langsam auflösenden Hartstoff aus einem Karbid, einem Nitrid, einem Borid, einem Phosphid, einem Silicid, einem Oxid, Oxynitrid, Oxycarbid, Oxycarbonitrid, einer NOSC (=Non-Oxide-Silicon-Ceramic) oder SiAlON und der Überzug aus einer BN-Schicht mit einer Härte von mehr als 3500 Vickers besteht.

2. Verbundkörper nach Anspruch 1, **dadurch gekennzeichnet**, daß die Eigenschaften des Überzuges durch chemische Zusätze (Doping) modifiziert sind.

3. Verbundkörper nach Anspruch 1 oder 2, **dadurch gekennzeichnet**, daß der Überzug bezüglich seiner optischen, mechanischen, thermischen, morphologischen, elektrischen und/oder chemischen Eigenschaften modifiziert sind.

4. Verbundkörper nach einem der Ansprüche 1 bis 3, **dadurch gekennzeichnet**, daß der Kern so klein ausgebildet ist, daß er als heterogener Keim für die Kristallisation des Bornitrids aus der damit übersättigten Gasphase anzusehen ist.

5. Verfahren zur Herstellung von Verbundkörpern nach einem der Ansprüche 1 bis 4, **dadurch gekennzeichnet**, daß die Substrate in einen Reaktionsraum gelegt oder aufgehängt und darin mittels chemischen Gasphasenabscheidungsverfahrens (CVD-Verfahren) mit Hilfe eines Gasstromes bei einer Temperatur zwischen 500 und 1200 °C und einem Druck unter 66 650 Pa beschichtet werden, wobei der Gasstrom aus einer gas- oder dampfförmigen Borverbindung oder einer Bor und Stickstoff enthaltenden Verbindung und/oder Wasserstoff und/oder Stickstoff und/oder Halogen und/oder deren Verbindungen mit oder ohne Edelgaszusatz besteht, und in diesen Fällen wenigstens eines der Gase durch ein physikalisches oder chemisches Verfahren in einen angeregten Zustand gebracht wurde.

6. Verfahren nach Anspruch 5, **dadurch gekennzeichnet**, daß der Gasstrom durch
a) eine stark erhitzte glühende Oberfläche eines festen Stoffes, vorzugsweise eine Metalloberfläche, vorzugsweise eine Metalloberfläche aus Tantal oder Wolfram, und/oder
b) eine Gasentladung im Unterdruck, ausgelöst von Gleich- oder Wechseiströmen, und/oder
c) ein Plasma, hergestellt durch elektromagnetische Wellen, vorzugsweise im Giga- und Megahertz-Bereich, und/oder
d) Ultraschall bzw. Druckwechsel und/oder
e) ein chemisches Verfahren unter Zersetzung mit Licht oder durch chemische Reaktion
angeregt wird, wobei in allen angeführten Fällen wenigstens eines der eingesetzten Gase vor oder während der Berührung mit dem zu umhüllenden Kern teilweise in einen angeregten Zustand versetzt wird und kurziebige und sich spontan in beständigere Stoffe umwandeinde Radikale und/oder atomare Spezien der eingesetzten Gase und/oder von Verbindungen, die sich aus den Gasgemischen bilden können, gebildet werden.

## Claims

1. A composite body comprising a substrate which is provided with a boron nitride coating adhering thereto, characterised in that the substrate comprises diamond or another carbon modification with a hardness of more than 3500 Vickers or a hard substance which does not react or which reacts at most slightly with carbon and/or boron nitride at temperatures of up to 1000°C and which does not dissolve them or dissolves them at most slowly at up to that temperature, the hard substance comprising a carbide, a nitride, a boride, a phosphide, a silicide, an oxide, an oxynitride, an oxycarbide, an oxycarbonitride, an NOSC (= Non-Oxide-Silicon-Ceramic) or SiAlON and the coating comprises a BN-layer with a hardness of more than 3500 Vickers.

2. A composite body according to claim 1 characterised in that the properties of the coating are modified by chemical additives (doping).

3. A composite body according to claim 1 or claim 2 characterised in that the coating is modified in respect of its optical, mechanical, thermal, morphological, electrical and/or chemical properties.

4. A composite body according to one of claims 1 to 3 characterised in that the core is so small that it is to be considered as a heterogeneous seed for crystallisation of the boron nitride out of the gas phase which is supersaturated therewith.

5. A process for the production of composite bodies according to one of claims 1 to 4 characterised in that the substrates are laid or suspended in a reaction chamber and coated therein by means of a chemical gaseous phase deposit process (CVD-process) by means of a gas flow at a temperature of between 500 and 1200°C and a pressure below 66 650 Pa, wherein the gas flow comprises a boron compound in gas or vapour form or a boron- and nitrogen-containing compound and/or hydrogen and/or nitrogen and/or halogen and/or compounds thereof with or without the addition of a noble gas, and in those cases at least one of the gases was put into an excited condition by a physical or chemical process.

6. A process according to claim 5 characterised in that the gas flow is excited by
a) a strongly heated incandescent surface of a solid substance, preferably a metal surface, preferably a metal surface of tantalum or tungsten, and/or
b) a gas discharge under reduced pressure, triggered by direct or alternating currents, and/or
c) a plasma, produced by electromagnetic waves, preferably in the Gigahertz and Megahertz range, and/or
d) ultrasound or pressure change and/or
e) a chemical process with decomposition with light or by chemical reaction
wherein in all the stated cases at least one of the gases used is partially put into an excited condition prior to or during contact with the core to be encased and short-lived radicals which spontaneously convert into more resistant substances and/or atomic species of the gases used and/or of compounds which can be formed from the gas mixtures are formed.

## Revendications

1. Corps composite consistant en un substrat qui est muni d'un revêtement de nitrure de bore y adhérant, caractérisé en ce que le substrat est constitué par du diamant ou une autre forme de carbone d'une dureté Vickers supérieure à 3500 ou par un matériau dur obtenu à partir d'un carbure, d'un nitrure, d'un borure, d'un phosphure, d'un siliciure, d'un oxyde, d'un oxynitrure, d'un oxycarbure, d'un oxycarbonitrure, d'un NOSC (= non oxide-silicone-ceramic) ou de SiAlON qui ne réagit pas ou au plus réagit peu avec le carbone et/ou le nitrure de bore à des températures jusqu'à 1000°C et ne les dissout pas ou tout au plus les dissout lentement jusqu'à cette température et que le revêtement est constitué par une couche de BN d'une dureté Vickers supérieure à 3500.

2. Corps composite selon la revendication 1, caractérisé en ce que les propriétés du revêtement sont modifiées par des additifs chimiques (dopage).

3. Corps composite selon la revendication 1 ou 2, caractérisé en ce que le revêtement est modifié en ce qui concerne ses propriétés optiques, mécaniques, thermiques, morphologiques, électriques et/ou chimiques.

4. Corps composite selon l'une des revendications 1 à 3, caractérisé en ce que le noyau se présente sous une forme tellement petite qu'il est à considérer comme germe héterogène pour la cristallisation du nitrure de bore à partir de la phase gazeuse sursaturée par celui-ci.

5. Procédé de fabrication de corps composites selon l'une des revendications 1 à 4, caractérisé en ce que les substrats sont placés ou suspendus dans un espace réactionnel et sont ensuite revêtus au moyen d'un procédé de dépôt chimique en phase gazeuse (procédé CVD) à l'aide d'un courant gazeux à une température entre 500 et 1200°C et sous une pression inférieure à 66 650 Pa, le courant gazeux étant constitué par un composé de bore à l'état gazeux ou de vapeur ou par un composé contenant du bore et de l'azote et/ou par de l'hydrogène et/ou de l'azote et/ou un halogène et/ou par leurs composés avec ou sans addition d'un gaz rare, et, dans ces cas, au moins un des gaz étant amené à l'état excité par un procédé physique ou chimique.

6. Procédé selon la revendication 5, caractérisé en ce que le courant gazeux est excité
a) par une surface fortement chauffée incandescente d'une substance solide, de préférence une surface métallique, de préférence une surface métallique de tantale ou de tungstène et/ou
b) par une décharge dans les gaz basse pression, amorcée par des courants continus ou alternatifs et/ou
c) par un plasma généré par des ondes électromagnétiques, de préférence dans la gamme des giga et mégahertzs et/ou
d) par des ultrasons, respectivement des variations de pression et/ou
e) par un procédé chimique avec décomposition par de la lumière ou par réaction chimique, moyennant quoi au moins un des gaz mis en oeuvre est, dans tous les cas rapportés, amené en partie à l'état excité avant ou pendant le contact avec le noyau à recouvrir et il se forme des radicaux à courte période et se transformant spontanément en des substances plus stables et/ou des espèces atomiques des gaz mis en oeuvre et/ou de composés susceptibles de se former à partir des mélanges gazeux.
